# FASCICULE DE BREVET EUROPEEN

(11) **EP 0 620 636 B1**
(45) Date de publication et mention de la délivrance du brevet: **15.10.1997**
(21) Numéro de dépôt: 94200944.0
(22) Date de dépôt: 07.04.1994
(51) Int. Cl.: H03B 5/12

(54) **Oscillateur à fréquence commandée par tension**
Oszillator mit einer spannungsgesteuerten Frequenz
Oscillator with a voltage-controlled frequency

(30) Priorité: 14.04.1993 FR 9304380
(43) Date de publication de la demande: 19.10.1994
(73) Titulaire: PHILIPS COMPOSANTS ET SEMICONDUCTEURS, 92150 Suresnes (FR); PHILIPS ELECTRONICS N.V., 5621 BA Eindhoven (NL)
(72) Inventeur: Philippe, Pascal, F-75008 Paris (FR)
(74) Mandataire: Charpail, François

(56) Documents cités:
- EP-A- 0 125 586
- EP-A- 0 270 298
- DE-A- 3 246 295
- US-A- 4 593 255

## Description

La présente invention concerne un oscillateur à fréquence commandée par tension comportant d'une part, un dispositif amplificateur qui présente un trajet principal de courant défini entre une première et une deuxième électrodes, et une électrode de commande pour la commande de la conduction de ce dispositif, comportant d'autre part un pont diviseur capacitif effectuant un couplage réactif entre la première électrode du dispositif et son électrode de commande, une extrémité du pont diviseur étant connectée à l'électrode de commande, l'autre extrémité connectée à une référence de tension et le noeud intermédiaire, connecté à la première électrode, oscillateur auquel est encore connecté un circuit d'accord, disposé entre l'électrode de commande et la référence de tension, lequel circuit comporte : une première branche parallèle formée d'une inductance d'accord en série avec une première capacité variable, et une deuxième branche parallèle équivalente à une deuxième capacité variable.

Un tel oscillateur, de type Colpitts, est connu du document EP-A-0 270 298. Il est notamment utilisé comme oscillateur local pour la réception de signaux de télévision.

Un problème technique constant dans ce domaine réside dans l'aptitude à couvrir une gamme de fréquence la plus étendue possible, à partir d'une inductance d'accord déterminée, tout en conservant des conditions fiables d'oscillation du dispositif amplificateur. Comme les valeurs d'impédance réactive sont susceptibles de varier dans des proportions élevées, de la fréquence la plus basse à la fréquence la plus élevée de la gamme de fréquence envisagée, il est nécessaire le plus souvent d'utiliser un circuit d'accord ayant une disposition relativement complexe, réalisant un compromis satisfaisant entre la sécurité de fonctionnement de l'oscillateur, et l'étendue de la gamme de fréquence couverte.

L'oscillateur connu préconise l'utilisation d'un circuit d'accord possédant ladite deuxième branche parallèle, dans le but d'élargir la gamme des fréquences couvertes par la variation de capacité de diodes varicaps qui constituent lesdites capacités variables. En ce qui concerne les fondements techniques à la base du fonctionnement d'un tel oscillateur, on se reportera utilement au document EP-A-0 270 298, déjà cité. Les difficultés à obtenir à la fois une gamme étendue de fréquences et une stabilité de fonctionnement de l'oscillateur dans toute l'étendue de cette gamme sont expliquées en détail dans ce même document, dont le contenu est incorporé par référence dans la présente demande de brevet. Il est indiqué que l'oscillateur connu est capable de couvrir plusieurs gammes de fréquences, la plus étendue ayant pour fréquences extrêmes : 263 et 509 MHz, soit un rapport de 1,93 entre ces fréquences. Il est souhaitable d'étendre ces possibilités et d'atteindre un rapport d'au moins 2,7 entre les fréquences extrêmes de la même gamme.

Ainsi l'invention a pour but de procurer un oscillateur ayant une gamme de fréquence très étendue, tout en asssurant des conditions fiables d'oscillation pour le dispositif amplificateur, dans toute l'étendue de la gamme de fréquence.

A cet effet, selon l'invention, un oscillateur du type défini dans le paragraphe introductif, est notamment remarquable en ce que le circuit d'accord comprend une troisième branche parallèle constituée d'une capacité fixe, et en ce que l'ensemble des première et troisième branches parallèles est relié au noeud de connexion entre l'électrode de commande du dispositif et la deuxième branche parallèle via une inductance série dont la valeur est inférieure à celle de l'inductance d'accord.

Ainsi, l'ensemble des première et troisième branches parallèles forme un circuit résonant qui peut être qualifié de combinaison d'un mode série et d'un mode parallèle.

En l'absence de l'inductance série prévue conformément à l'invention, le compromis reste encore trop étroit entre la largeur de la bande de fréquence couverte, et la stabilité de l'oscillation aux fréquences limites de la bande. En effet, lorsqu'on cherche à élargir la bande de fréquence, l'impédance du circuit d'accord décroît. Lorsque cette impédance est trop faible, l'oscillation cesse de se produire car le circuit d'accord dissipe plus d'énergie que le dispositif amplificateur peut en fournir.

Comme cela sera discuté plus en détail par la suite, l'insertion de l'inductance série introduit une possibilité de résonance à une autre fréquence que celle qui est déterminée par l'inductance d'accord et la combinaison série-parallèle des capacités prévues dans le circuit d'accord. C'est pourquoi, la valeur de l'inductance série est choisie comme étant une fraction seulement de la valeur de l'inductance d'accord, de sorte que la fréquence indésirable précitée, est nettement plus élevée que la fréquence qui se déduit de l'inductance d'accord. Elle peut être rendue si élevée que cette oscillation parasite, en réalité, ne se produit pas.

Dans un mode préféré de mise en oeuvre de l'invention, l'oscillateur se caractérise en ce que la deuxième branche parallèle est constituée d'une capacité fixe en série avec une diode à capacité variable, d'un même modèle que la diode à capacité variable constituant ladite première capacité variable.

Par un choix convenable des valeurs de la capacité fixe comprise dans la deuxième branche parallèle et de la capacité fixe constituant la troisième branche parallèle, il est donc possible d'utiliser deux diodes à capacité variable du même modèle, lesquelles sont avantageusement commandées à partir d'une même tension variable de commande.

Il s'ensuit une simplification correspondante pour la réalisation pratique de l'oscillateur.

La description qui va suivre au regard des dessins annexés donnés à titre d'exemples non limitatifs, fera bien comprendre en quoi consiste l'invention et comment elle peut être réalisée.
La figure 1 donne un schéma de principe de l'oscillateur selon l'invention, et
La figure 2, le schéma électrique d'un exemple de réalisation de cet oscillateur.

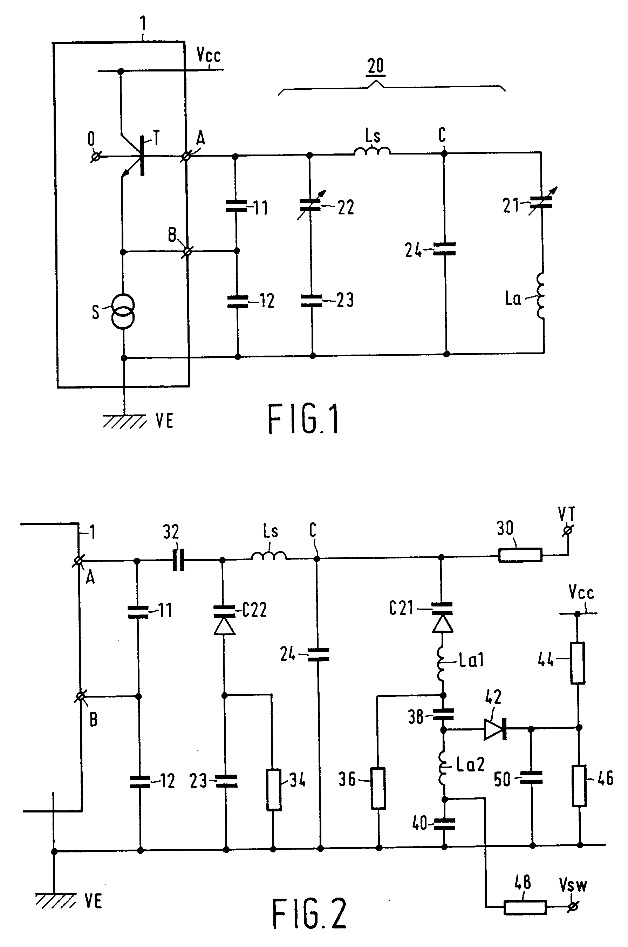

L'oscillateur représenté à la figure 1, de manière très schématique, comporte une portion de circuit 1, à résistance négative, dans laquelle un transistor T constitue un dispositif amplificateur dont le trajet principal de courant est alimenté entre une tension d'alimentation Vcc et une tension de référence VE. A la base du transistor T est connectée une borne A, et à l'émetteur de ce transistor une borne B. L'émetteur du transistor T est par ailleurs relié à la tension de référence VE via une source de courant S. Dans la portion du circuit 1, seul a été représentés le transistor T et la source de courant S alors que d'autres fonctionalités non représentées peuvent être également incorporées sous forme de circuit intégré monolithique, fonctionalités qui ne concerne pas directement l'invention. Le signal d'oscillation généré par le transistor T peut être prélevé sur la base de ce transistor, ce qui est représenté symboliquement sur la figure par la borne de sortie 0.

Un pont diviseur capacitif réalise un couplage réactif entre l'émetteur du transistor T et la base de ce transistor, lequel pont diviseur est constitués des condensateurs 11 et 12 disposés en série, l'extrémité libre du condensateur 11 connectée à la borne A (base du transistor T) et l'extrémité libre du condensateur 12 connecté à la tension de référence VE. Le point commun entre les condensateurs 11 et 12 est connecté à la borne B (émetteur du transistor T).

Entre la borne A et la tension de référence VE est encore disposé un circuit d'accord 20 constitué d'une première branche parallèle formée d'une inductance d'accord La en série avec une capacité variable 21 et une deuxième branche parallèle constituée par une deuxième capacité variable 22 en série avec une capacité fixe 23, cette branche étant équivalente à une capacité variable.

Une troisième branche en parallèle sur la première branche 21, La, est constituée d'un condensateur fixe 24. A l'opposé de la tension de référence VE, les première (21, La) et troisième (24) branches parallèles sont réunies en un noeud C. Du côté opposé à la tension de référence VE, le pont diviseur 11, 12 et la deuxième branche parallèle 22, 23 sont directement connectés à la borne A. Selon une particularité essentielle de l'invention le noeud C est relié à la borne A via une inductance série Ls dont la valeur est inférieure à celle de l'inductance d'accord La. Comme il sera indiqué plus en détail par la suite, l'inductance série Ls fournit un moyen efficace pour assurer que les conditions d'oscillation restent vérifiées aux fréquences les plus élevées lorsque la gamme des fréquences sur laquelle l'oscillateur peut être accordé à été étendue. La présence de l'inductance série Ls entraîne le fait que le circuit d'accord 20 est susceptible d'entrer en résonance sur deux fréquences : l'une dite principale déterminée principalement par l'inductance d' accord La et l'autre, dite parasite déterminée par l'inductance série Ls.

Comme cette dernière à été choisie d'une valeur faible devant l'inductance La, il existe une fréquence élevée telle que l'inductance d'accord La présente une réactance importante devant la réactance du condensateur 24 de sorte qu'au noeud C, l'influence du condensateur 24 est prépondérante.

A l'autre borne de l'inductance Ls, c'est-à-dire sur le noeud A, la réactance par rapport à la tension de référence VE se réduit à une capacitance résultant de la combinaison des condensateurs 11, 12, 23 et de la capacité variable 22.

La fréquence de résonance parasite peut donc être calculée et elle sera déterminée principalement par le choix de la valeur des capacités 11, 12, 24 et de l'inductance Ls.

Comme l'inductance Ls a été choisie de faible valeur devant l'inductance d'accord La, il est aisé de faire en sorte que la fréquence de résonance parasite soit reportée nettement au-delà de la fréquence la plus élevée de la gamme des fréquences dans le mode dit principal, de sorte que les conditions d'oscillation sur la fréquence parasite ne soient pas réalisées.

On va examiner maintenant de manière qualitative, quel est le rôle et l'influence de l'inductance série Ls.

Supposons tout d'abord, que l'inductance série Ls et la deuxième branche parallèle composées des capacités 22 et 23 soient omises, le noeud C étant connecté directement à la borne A en parallèle sur le pont diviseur capacitif 11, 12. Dans ce cas, la capacité 24 qui se trouve en parallèle sur le pont diviseur 11, 12 à pour effet d'augmenter la capacité équivalente en parallèle sur la première branche 21, La. Pour étendre la gamme de fréquences vers les fréquences les plus basses possibles il y aurait donc lieu de choisir une capacité parallèle 24 de valeur la plus élevée possible.

Toutefois, dans ce cas les conditions d'oscillation ne sont plus réunies dans le haut de la gamme de fréquences car l'impédance vue par le dispositif amplificateur T est alors insuffisante. Pour obtenir une impédance convenable assurant une oscillation dans la portion des fréquence élevées il y aurait lieu de choisir une capacité parallèle 24 qui soit plus faible. Un compromis assurant une large gamme de fréquences n'est donc pas possible. Supposons maintenant, que la capacité parallèle 24 soit omise et remplacée par ladite deuxième branche parallèle constituée de la capacité variable 22 et de la capacité fixe 23. Cette disposition correspond à l'oscillateur connu par le document EP-A-0 270 298 déjà cité. Par rapport au cas envisagé précédemment, les conditions sont plus favorables puisque la capacité parallèle équivalente aux capacités en série 22 et 23, devient faible du fait de la capacité variable 22 lorsque l'on se place à la limite élevée de la gamme de fréquence, et qu'elle augmente à l'autre extrémité de la gamme, pour les fréquences les plus basses.

Un élargissement de la gamme de fréquence est aussi obtenu aux fréquences élevées, qui est toutefois peu important du fait que la capacité variable 22, bien que faible, se trouve en parallèle sur le pont diviseur 11, 12, lequel présente alors une influence prépondérante. Un accroissement significatif de la gamme d'accord nécessite d'augmenter la capacité parallèle équivalente en limite basse de la gamme de fréquences. Il est important cependant que la capacité parallèle présente un coefficient de qualité élevé afin de ne pas abaisser sensiblement l'impédance du circuit d'accord aux fréquences les plus basses, ce qui rendrait critique le fonctionnement de l'oscillateur à ces fréquences. Pour cette raison, l'augmentation de la capacité parallèle équivalente obtenu par la simple augmentation de la valeur de la capacité 23 n'est pas une solution satisfaisante. Un coefficient de qualité plus élevé est obtenu si la capacité parallèle équivalente est augmentée au moyen d'une capacité supplémentaire (24) de valeur fixe, ajoutée en parallèle sur la branche de capacité variable. Il s'ensuit une certaine diminution de l'impédance aux fréquences élevées par rapport à la situation précédente qui est compensée dans la présente invention par l'addition de l'inductance série Ls.

Selon l'invention, une gamme de fréquence étendue est obtenue en utilisant deux branches capacitives respectivement 24 et 22, 23 en parallèle sur la première branche d'accord La, 21, et en interposant l'inductance série Ls entre le noeud A et le noeud C. De cette manière, le niveau d'impédance du circuit d'accord peut être adapté de façon quasi optimale à celui requis pour obtenir un bon fonctionnement de l'oscillateur sur la gamme de fréquence recherchée. Aux fréquences les plus élevées, le choix d'une capacité 24 de valeur relativement faible contribue à élever le niveau d'impédance du circuit d'accord. Le fonctionnement de l'oscillateur à ces fréquences est également rendu plus aisé par la présence de l'inductance Ls. Des calculs détaillés montrent que cette inductance a pour effet d'élever l'impédance du circuit d'accord tout en ayant peu d'effet sur la fréquence d'oscillation. Ces effets combinés avantageux peuvent être obtenus avec des valeurs de la capacité 24 et de l'inductance Ls telles que tout risque d'oscillation dans le mode parasite soit normalement écarté. Si, pour quelque raison, un risque d'oscillation parasite subsistait, il est possible de l'éliminer définitivement par l'addition d'une faible résistance en série avec l'inductance Ls, sans perturber notablement le fonctionnement dans le mode recherché.

Aux fréquences les plus basses de la gamme de fréquence recherchée, l'impédance de l'inductance série Ls devient pratiquement négligeable de sorte qu'à la capacité 24 s'ajoutent en parallèle les capacités du pont diviseur 11, 12 et de la deuxième branche capacitive 22, 23. En utilisant des capacités variables 21 et 22 variant entre 2,5 pF et 40 pF, on constate qu'en pratique, il est possible de couvrir une gamme ayant un rapport de fréquences extrêmes qui est aussi élevé qu'un facteur 2,8, pour une inductance d'accord La de valeur donnée. En conservant les mêmes éléments, et en ajoutant en série avec l'inductance d'accord La, une deuxième inductance d'accord de valeur plus élevée il est également possible de couvrir une gamme de fréquences plus basses dont le rapport des fréquences extrêmes est encore égal à 2,8, l'oscillateur ainsi réalisé étant stable dans toute l'étendue de ces deux gammes de fréquences.

Un exemple de mise en oeuvre pratique de l'invention, est représenté par l'oscillateur de la figure 2. Sur la figure 2, les éléments correspondant à la figure 1 et assurant la même fonction sont affectés des mêmes signes de référence.

Les capacités variables 22 respectivement 21 de la figure 1 sont ici réalisées au moyen de diodes à capacité variable C22 respectivement C21, de même modèle, commandées toutes les deux à partir de la même tension d'ajustage VT qui est appliqué au noeud C via une résistance de blocage 30 de valeur élevée. L'isolement en courant continu entre le noeud C et la borne A est assuré au moyen d'une capacité de liaison 32 de valeur élevée choisie pour que sa réactance soit faible dans toute la gamme des fréquences.

L'anode de la diode C22 est portée au potentiel continu de la tension de référence VE (masse) au moyen d'une résistance de blocage 34 tandis qu'une disposition similaire est appliquée à la diode C21 dont l'anode, à travers l'inductance d'accord La1, est portée au potentiel continu de référence VE via une résistance de blocage 36. Entre l'inductance La1 et la tension de référence VE est insérée, du point de vue de la haute fréquence, une inductance supplémentaire La2 dont la valeur est plus élevée que l'inductance La1, la somme de ces inductances étant utilisée pour couvrir la gamme la plus basse des fréquences recherchées.

Au point de vue de la tension continue, un isolement est réalisé de part et d'autre de l'inductance supplémentaire La2 par des capacités 38 et 40 de valeurs élevées de sorte qu'aux fréquences utilisées l'impédance de ces capacités soit négligeable.

Un circuit de commutation de bande est réalisé au moyen d'une diode de commutation 42 dont l'anode est connectée entre la capacité 38 et l'inductance La2 et dont la cathode est portée à un potentiel intermédiaire entre la tension d'alimentation Vcc et la tension de référence VE au moyen d'un pont résistif 44, 46. Enfin, l'anode de la diode de commutation 42 peut être portée soit une tension égale à Vcc pour placer cette diode en conduction, soit à une tension égale à la tension de référence VE pour placer cette diode en blocage, ceci sous l'effet d'un signal de commutation Vsw appliqué via une résistance d'isolement 48 au noeud rejoignant la capacité 40 et l'inductance supplémentaire La2. Lorsque la diode 42 est conductrice, elle transmet le signal alternatif à la tension de référence VE à travers une capacité 50 choisie d'une valeur élevée telle que son impédance soit négligeable en alternatif.

En dehors des éléments accessoires utilisés pour effectuer la commutation de gamme de fréquences, le schéma de la figure 2 est conforme au principe du schéma de la figure 1, dans lequel l'inductance d'accord La peut prendre deux valeurs distinctes. L'oscillateur de la figure 2, permet en pratique de couvrir la bande de fréquence de télévision VHF de 87 à 204 MHz ainsi que la bande VHF de 188 à 513 MHz dans une construction où les éléments ont les valeurs suivantes :

| **Capacités** | |
|---|---|
| Références | Valeurs |
| 11, 12 | 15 pF |
| 23 | 47 pF |
| 24 | 8 pF |
| C21, C22 | 2,5 à 40 pF |
| 32 | 100 pF |
| 38, 40, 50 | 1nf |

| **Inductances** | |
|---|---|
| La1 | 35 nH |
| La2 | 160 nH |
| Ls | 7 nH |

| **Résistances** | |
|---|---|
| 30, 34, 36 | 27 KOhms |
| 48 | 390 Ohms |
| 44 | 1 KOhms |
| 46 | 680 Ohms |

| **Tensions** | |
|---|---|
| Vcc | 5 Volts |
| VE | 0 |
| Vsw | 0 ou 5 Volts |
| VT | 0,5 à 28 Volts |

Bien entendu, d'autres gammes de fréquence que celles données dans l'exemple peuvent être obtenues au moyen de l'invention.

La valeur des éléments à prévoir pour couvrir une gamme déterminée de fréquences se déduit de calculs simples, à la portée du spécialiste.

L'invention ne se limite pas à l'utilisation d'un transistor bipolaire en tant que dispositif amplificateur T, tel que décrit dans les exemples, mais s'applique également à tout autre dispositif, transistor à effet de champ notamment, dès lors qu'un couplage réactif peut être réalisé entre son électrode de commande (grille) et sa première électrode (source), le trajet principal de courant étant défini entre source et drain.

## Revendications

1. Oscillateur à fréquence commandée par tension comportant d'une part, un dispositif amplificateur (T) qui présente un trajet principal de courant défini entre une première et une deuxième électrodes, et une électrode de commande pour la commande de la conduction de ce dispositif, comportant d'autre part un pont diviseur capacitif (11, 12) effectuant un couplage réactif entre la première électrode du dispositif et son électrode de commande, une extrémité du pont diviseur étant connectée à l'électrode de commande, l'autre extrémité connectée à une référence de tension (VE) et le noeud intermédiaire, connecté à la première électrode, oscillateur auquel est encore connecté un circuit d'accord (20), disposé entre l'électrode de commande et la référence de tension, lequel circuit comporte : une première branche parallèle formée d'une inductance d'accord (La) en série avec une première capacité variable (21), une deuxième branche parallèle équivalente à une deuxième capacité variable (22, 23), caractérisé en ce que le circuit d'accord comprend une troisième branche parallèle constituée d'une capacité fixe (24), et en ce que l'ensemble des première et troisième branches parallèles est relié au noeud de connexion (A) entre l'électrode de commande du dispositif et la deuxième branche parallèle via une inductance série (Ls) dont la valeur est inférieure à celle de l'inductance d'accord (La).

2. Oscillateur selon la revendication 1, caractérisé en ce que la deuxième branche parallèle est constituée d'une capacité fixe (23) en série avec une diode à capacité variable (C22), d'un même modèle que la diode à capacité variable (C21) constituant ladite première capacité variable.

3. Oscillateur selon la revendication 2, caractérisé en ce que les deux diodes à capacité variable (C21, C22) sont commandées à partir d'une même tension variable de commande (VT).

4. Oscillateur selon l'une quelconque des revendications 1 à 3, caractérisé en ce que le dispositif amplificateur (T) est un transistor bipolaire dont la base constitue l'électrode de commande, l'émetteur constitue ladite première électrode et le collecteur, ladite deuxième électrode.

## Patentansprüche

1. Die vorliegende Erfindung betrifft einen Oszillator mit einer spannungsgesteuerten Frequenz, bestehend einerseits aus einer Verstärkereinrichtung (T), die einen zwischen einer ersten und einer zweiten Elektrode definierten Hauptstromweg und eine Steuerelektrode für die Leitungssteuerung der Einrichtung aufweist, bestehend andererseits aus einer kapazitiven Teilerbrücke (11, 12), die eine reaktive Kopplung zwischen der ersten Elektrode der Einrichtung und ihrer Steuerelektrode vornimmt, wobei ein Ende der Teilerbrücke an die Steuerelektrode, das andere Ende an eine Spannungsreferenz (VE) und der Zwischenknoten an die erste Elektrode angeschlossen ist, während an den Oszillator zusätzlich zwischen der Steuerelektrode und der Spannungsreferenz ein Abstimmkreis (20) angeschlossen ist und die Schaltung folgendes enthält :
einen ersten aus einer Abstimminduktanz (La) in Serie mit einer ersten variablen Kapazität (21) gebildeten parallelen Zweig und einen zweiten, mit einer zweiten variablen Kapazität (22, 23) äquivalenten parallelen Zweig, mit dem Merkmal, daß die Abstimmschaltung einen dritten, aus einer festen Kapazität (24) gebildeten parallelen Zweig enthält und daß die Gesamtheit der ersten und dritten parallelen Zweige mit einem Verbindungsknoten (A) zwischen der Steuerelektrode der Einrichtung und dem zweiten parallelen Zweig verbunden ist, über eine Serieninduktanz (Ls), deren Wert unter dem der Abstimminduktanz (La) liegt.

2. Ein Oszillator laut Anspruch 1, mit dem Merkmal, daß der zweite parallele Zweig aus einer festen Kapazität (23) in Serie mit einer Diode variabler Kapazität (C22) gebildet wird, selben Modells wie die Diode variabler Kapazität (C21), die die besagte erste variable Kapazität bildet.

3. Ein Oszillator laut Anspruch 2, mit dem Merkmal, daß die beiden Dioden variabler Kapazität (C21, C22) mit derselben variablen Steuerspannung (VT) gesteuert werden.

4. Ein Oszillator laut einem beliebigen der Ansprüche 1 bis 3, mit dem Merkmal, daß die Verstärkereinrichtung (T) ein Bipolartransistor ist, dessen Basis die Steuerelektrode bildet, während der Emitter die besagte erste Elektrode und der Kollektor die besagte zweite Elektrode bildet.

## Claims

1. A voltage-controlled frequency oscillator comprising an amplifier device (T) which has a main current path defined between a first and a second electrode, and a control electrode for controlling the conduction of said device, and comprising a capacitive divider bridge (11, 12) effecting a feedback coupling between the first electrode of the device and its control electrode, while one terminal of the divider bridge is connected to the control electrode and the other terminal is connected to a reference voltage (VE) and the intermediate junction point connected to the first electrode, said oscillator being also connected to a tuning circuit (20) arranged between the control electrode and the reference voltage, which circuit comprises a first parallel branch constituted by a tuning inductance (La) arranged in series with a first variable capacitance (21) and a second parallel branch equivalent to a second variable capacitance (22, 23), characterized in that the tuning circuit comprises a third parallel branch constituted by a fixed capacitance (24), and in that the assembly of first and third parallel branches is connected to the junction point (A) between the control electrode of the device and the second parallel branch via a series inductance (Ls) which has a smaller value than the tuning inductance (La).

2. An oscillator as claimed in claim 1, characterized in that the second parallel branch is constituted by a fixed capacitance (23) arranged in series with a variable capacitance diode (C22) of the same model as the variable capacitance diode (C21) constituting said first variable capacitance.

3. An oscillator as claimed in claim 2, characterized in that the two variable capacitance diodes (C21, C22) are controlled by the same variable control voltage (VT).

4. An oscillator as claimed in any one of claims 1 to 3, characterized in that the amplifier device (T) is a bipolar transistor whose base constitutes the control electrode, the emitter constitutes said first electrode and the collector constitutes said second electrode.
